# EUROPÄISCHE PATENTANMELDUNG

(11) **EP 0 637 753 A2**
(43) Veröffentlichungstag der Anmeldung: **08.02.1995**
(21) Anmeldenummer: 94111494.4
(22) Anmeldetag: 22.07.1994
(51) Int. Cl.: G01R 19/00, H04N 5/60, H04S 1/00, H04H 5/00

(54) **Schaltungsanordnung zur Feststellung einer Frequenz in einem zusammengesetzten Signal**

(30) Priorität: 06.08.1993 DE 4326524
(71) Anmelder: SIEMENS AKTIENGESELLSCHAFT, D-80333 München (DE)
(72) Erfinder: Stepp, Richard, Dipl.-Ing., D-80796 München (DE)

(57) **Zusammenfassung**

Schaltungsanordnung zur Feststellung des Vorhandenseins oder Nichtvorhandenseins mindestens einer Frequenz bekannten Wertes in einem aus mehreren Frequenzen zusammengesetzten Eingangssignal mit Mitteln (22, 24, 25) zur Erzeugung zweier gleichfrequenter zueinander um 90° phasenverschobener Referenzsignale (14, 15), Mitteln (12, 13) zur Mischung der Referenzsignale (14, 15) mit einem aus dem Eingangssignal (1) abgeleiteten Zwischensignal, Mitteln (16, 17) zur Bandbegrenzung der sich daraus ergebenden Mischprodukte, Mitteln (18, 19) zur Amplitudenbewertung der bandbegrenzten Mischprodukte, die ein das Vorhandensein oder Nichtvorhandensein der Frequenz(en) bekannten Wertes anzeigendes Ausgangssignal (20, 21) abgeben, Mitteln (22, 23, 24) zur Erzeugung zweier gleichfrequenter, zueinander um 90° phasenverschobener, weiterer Referenzsignale (4, 5), Mitteln (2, 3) zur Mischung der weiteren Referenzsignale (4, 5) mit dem Eingangssignal (1), Mitteln (6, 7) zur Bandbegrenzung der sich daraus ergebenden weiteren Mischprodukte und das Zwischensignal erzeugenden Mitteln (8, 9, 10) zur Quadrierung und anschließenden Addition der bandbegrenzten weiteren Mischprodukte.

## Beschreibung

Die Erfindung betrifft eine Schaltungsanordnung zur Feststellung des Vorhandenseins oder Nichtvorhandenseins mindestens einer Frequenz bekannten Wertes in einem aus mehreren Frequenzen zusammengesetzten Signal mit Mitteln zur Erzeugung zweier gleichfrequenter zueinander um 90° phasenverschobener Referenzsignale, Mitteln zur Mischung der Referenzsignale mit dem Signal,Mitteln zur Bandbegrenzung der sich daraus ergebenden Mischprodukte und Mitteln zur Amplitudenbewertung der bandbegrenzten Mischprodukte, die ein das Vorhandensein oder Nichtvorhandensein der Frequenz(en) bekannten Wertes anzeigendes Ausgangssignal abgeben,
Eine derartige Schaltungsanordnung ist beispielsweise aus der europäischen Patentanmeldung 0 356 555 oder der deutschen Offenlegungsschrift 33 40 325 bekannt und wird hauptsächlich zur Dekodierung der Programmarterkennung im Zweiträger-Fernsehtonsystem angewendet. Danach erfolgt die Programmarterkennung mit Hilfe eines amplitudenmodulierten Pilotträgertones, dessen Frequenz gleich dem 3,5fachen der Videozeilenfrequenz von 15625 Hz ist. Bei Betriebsart Stereo ist dem Pilotträger durch Amplitudenmodulation ein Kennton mit einer Frequenz von 15625/133 Hz aufmoduliert. Demgegenüber wird bei Zweitonbetrieb dem Pilotträgerton ein Kennton mit der Frequenz von 15625/57 Hz aufmoduliert.

Bei der Betriebsart Mono schließlich ist der Pilotträgerton ummoduliert oder überhaupt nicht vorhanden.

Werden bei den bekannten Schaltungsanordnungen die Referenzsignale nicht aus der Zeilenfrequenz, sondern aus der Frequenz eines zusätzlichen Oszillators, beispielsweise eines Quarzoszillators, abgeleitet, so ist eine sehr hohe, schwer einzuhaltende Konstanz der Frequenz des zusätzlichen Oszillators von besser als 10 ppm erforderlich.

Aufgabe der Erfindung ist es, eine Schaltungsanordnung zur Feststellung des Vorhandenseins oder Nichtvorhandenseins mindestens einer Frequenz bekannten Wertes in einem aus mehreren Frequenzen zusammengesetzten Eingangssignal anzugeben, die eine geringere Konstanz der Referenzsignale erlaubt.

Die Aufgabe wird bei einer Schaltungsanordnung der eingangs genannten Art gelöst durch Mittel zur Erzeugung zweier gleichfrequenter, zueinander um 90° phasenverschobener, weiterer Referenzsignale, Mittel zur Mischung der weiteren Referenzsignale mit einem Eingangssignal, Mittel zur Bandbegrenzung der sich daraus ergebenden weiteren Mischprodukte, das Signal erzeugende Mittel zur Quadrierung und anschließenden Addition der bandbegrenzten weiteren Mischprodukte und einen Oszillator zur Erzeugung der Referenzsignale, an den unter Zwischenschaltung jeweils einer Frequenzteilereinheit mit bestimmtem Teilverhältniszwei Phasenschiebereinheiten angeschlossen sind.

Bei einer Weiterbildung der Erfindung ist vorgesehen, auch die Bandbreite der Zwischensignale zu begrenzen, wobei die Frequenzcharakteristik beispielsweise abhängig von der Betriebsart veränderbar sein kann.

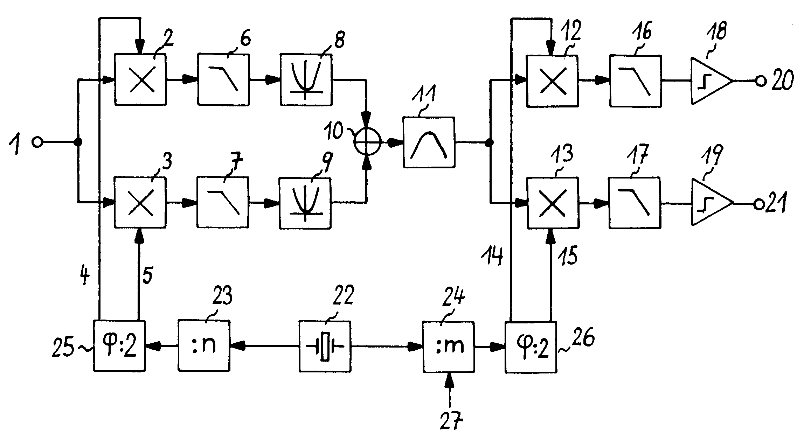

Die Erfindung wird nachfolgend anhand des in der einzigen Figur der Zeichnung dargestellten Ausführungsbeispiels näher erläutert.

Bei der gezeigten Schaltungsanordnung wird ein Eingangssignal 1, das auf das Vorhandensein oder Nichtvorhandensein einer Frequenz bekannten Wertes hin untersucht werden soll, zwei Mischern 2, 3 zugeführt. Das Eingangssignal 1 wird dabei mit Referenzsignalen 4, 5 multipliziert, die jeweils an einen der Mischer 2, 3 angelegt sind und die gleichfrequent, jedoch zueinander um 90° phasenverschoben sind. Den Mischern 2, 3 ist jeweils ein Tiefpaß 6, 7 und diesen wiederum jeweils eine Quadriereinrichtung 8, 9 nachgeschaltet. Die Ausgänge der Quadrierer 8 und 9 sind auf einen Addierer 10 geführt, dem wiederum in Weiterbildung der Erfindung ein Bandpaß 11 zur Bandbegrenzung nachgeschaltet ist.

Ein am Ausgang des Addierers 10 anliegendes und durch den Bandpaß 11 bandbegrenztes Zwischensignal wird zwei Mischstufen 12 und 13 zugeführt, die das Zwischensignal mit Referenzsignalen 14 bzw. 15 multiplizieren. Die Referenzsignale 14 und 15 sind gleichfrequent, jedoch zueinander um 90° phasenverschoben. Den Mischern 12 und 13 sind jeweils Tiefpässe 16 und 17 zur Bandbegrenzung nachgeschaltet, denen jeweils ein Fensterkomparator 18 bzw. 19 zur Amplitudenbewertung folgt. Die beiden Komparatoren 18 und 19 mit jeweils gegebenen Schwellwerten erzeugen zwei Ausgangssignale 20 und 21, die Informationen über das Vorhandensein oder Nichtvorhandensein der festzustellenden Frequenz(en) im Eingangssignal 1 beinhalten.

Zur Erzeugung der Referenzsignale 4, 5 bzw. 14, 15 ist ein Quarzoszillator 22 vorgesehen, der unter Zwischenschaltung jeweils eines Teilers 23 bzw. 24 mit einem gegebenen Teilerverhältnis n bzw. m eine Phasenschiebeeinrichtung 25 bzw. 26 ansteuert.

Zur Erläuterung der Funktionsweise einer erfindungsgemäßen Schaltungsanordnung wird davon ausgegangen, daß das Eingangssignal 1 durch ein Frequenzgemisch bestehend aus dem Audiosignal und dem (modulierten) Pilotton gegeben ist. Am jeweils anderen Eingang der beiden Mischer 2, 3 liegen die beispielsweise rechteckförmigen Referenzsignale 4 und 5 an, die durch Phasenverschiebung um 90° zueinander aus einem gemeinsamen Signal hervorgehen. Die Frequenz der beiden Referenzsignale 4 und 5 ist gleich der 3,5fachen Videozeilenfrequenz zu-/abzüglich der Toleranz der Quarzfrequenz. Am Ausgang der Mischer 2 und 3 stehen amplitudenmodulierte Signale zur Verfügung, die gleich den Summen- und Differenzsignalen des Pilotträgertons und des Referenzsignals 4 bzw. 5 sind. Mit den nachfolgenden Tiefpässen 6 und 7 werden die dabei entstehenden Summenterme unterdrückt und zugleich unerwünschte Audioanteile gedämpft. Am Ausgang der Tiefpässe 6 und 7 tritt jeweils ein Signal auf, das gleich dem Differenzsignal aus den Pilotträgerton und dem Referenzsignal 4 bzw. 5 multipliziert mit dem Modulationssignal ist. Mit Hilfe der beiden Quadrierer 8 und 9 werden diese beiden Signale für sich quadriert und anschließend miteinander addiert. Da beide Signale ebenfalls zueinander um 90° phasenverschoben sind, erscheint am Ausgang des Addierers 10 nur noch das quadrierte Modulationssignal. Die durch die Toleranz der Quarzfrequenz bedingte Schwebungsfrequenz wird also weitestgehend unterdrückt. Das quadrierte Modulationssignal beinhaltet einen Gleichanteil, den entsprechenden Kennton für Stereobetrieb bzw. Zweitonbetrieb sowie deren Harmonische. Mittels des Bandpasses 11 können die gewünschten Komponenten hervorgehoben werden, wenn die lineare Eingangskennlinie der nachfolgenden Mischer 12 und 13 nicht hinreichend groß ist. Andernfalls kann auf den Bandpaß 11 verzichtet werden. Die nachfolgende Anordnung mit den Mischern 12 und 13, den Tiefpässen 16 und 17 sowie den Amplitudenbewertungseinrichtungen 18 und 19 wertet in (beispielsweise aus den eingangs genannten Dokumenten) bekannter Weise das Zwischensignal hinsichtlich des Vorliegens oder Nichtvorliegens der gesuchten Frequenz aus. Die Amplitudenbewertungseinrichtungen 18 und 19 können außerdem auch entweder durch einen Komparator mit fest vorgegebenem Schwellwert oder durch eine Anordnung, die die Quadratwurzel aus der Summe der Quadrate bildet, realisiert werden.

Die benötigten Referenzfrequenzen 4, 5, 14 und 15 werden hierbei bevorzugt aus einem Quarzoszillator, nämlich dem Quarzoszillator 22, durch Frequenzteilung gewonnen. Eine bevorzugte Anordnung benutzt beispielsweise eine Quarfrequenz von 3,5 MHz, die durch Teiler 23 um n = 32 sowie durch den als Johnson Counter ausgebildeten Phasenschieber 25 durch 2, also durch insgesamt 64, zur Erzeugung der beiden Referenzsignale 4 und 5 geteilt wird. Zur Erzeugung der Referenzsignale 14 und 15 wird insgesamt ein Teilerverhältnis von 29792 bei Stereobetrieb und 12768 bei Zweitonbetrieb benötigt. Da der Phasenschieber 26 wiederum als Johnson Counter ausgeführt ist, ist beim Teiler 24 ein Teilerverhältnis von 14896 oder 6384 notwendig. Jedoch ist mit Hilfe eines beliebigen Frequenzsynthesizers auch jede andere Quarzfrequenz benutzbar. Außerdem kann in gleicher Weise mit Hilfe eines Phasenregelkreises auch auf die Zeilenfrequenz synchronisiert werden.

Da das Teilerverhältnis des Teilers 24 mittels eines Steuersignals 27 umschaltbar ist, wird in Weiterbildung der Erfindung auch die Mittenfrequenz des Bandpasses 11 der jeweiligen Betriebsart angepaßt. Das bedeutet, daß bei Stereobetrieb die Mittenfrequenz des Bandpasses 11 gleich einem 133tel der Zeilenfrequenz und bei Zweitonbetrieb dem 57ten Teil der Zeilenfrequenz ist. Sämtliche benötigten Filter können sowohl als analoge Filter als Switched-Capacitor-Filter oder als digitale Filter ausgeführt werden. Weiterhin ist dieses Prinzip aber auch gänzlich in Digitaltechnik realisierbar.

## Patentansprüche

1. Schaltungsanordnung zur Feststellung des Vorhandenseins oder Nichtvorhandenseins mindestens einer Frequenz bekannten Wertes in einem aus mehreren Frequenzen zusammengesetzten Signal mit Mitteln (22, 24, 26) zur Erzeugung zweier gleichfrequenter zueinander um 90° phasenverschobener Referenzsignale (14, 15),
Mitteln (12, 13) zur Mischung der Referenzsignale (14, 15) mit dem Signal,
Mitteln (16, 17) zur Bandbegrenzung der sich daraus ergebenden Mischprodukte und
Mitteln (18, 19) zur Amplitudenbewertung der bandbegrenzten Mischprodukte, die ein das Vorhandensein oder Nichtvorhandensein der Frequenz(en) bekannten Wertes anzeigendes Ausgangssignal (20, 21) abgeben,
**gekennzeichnet durch**
Mittel (22, 23, 25) zur Erzeugung zweier gleichfrequenter, zueinander um 90° phasenverschobener, weiterer Referenzsignale (4, 5),
Mittel (2, 3) zur Mischung der weiteren Referenzsignale (4, 5) mit einem Eingangssignal (1),
Mittel (6, 7) zur Bandbegrenzung der sich daraus ergebenden weiteren Mischprodukte,
das Signal erzeugende Mittel (8, 9, 10) zur Quadrierung und anschließenden Addition der bandbegrenzten weiteren Mischprodukte und
einen Oszillator (22) zur Erzeugung der Referenzsignale (4, 5, 14, 15), an den unter Zwischenschaltung jeweils einer Frequenzteilereinheit (23, 24) mit bestimmtem Teilverhältnis (n, m) zwei Phasenschiebereinheiten (25, 26) angeschlossen sind.

2. Schaltungsanordnung nach Anspruch 1,
**gekennzeichnet durch** Mittel (11) zur Bandbegrenzung des Signals.

3. Schaltungsanordnung nach Anspruch 2,
**dadurch gekennzeichnet,** daß bei den Mitteln (11) zur Bandbegrenzung des Signals die Frequenzcharakteristik veränderbar ist.

4. Schaltungsanordnung nach einem der Ansprüche 1 bis 3,
**dadurch gekennzeichnet,** daß zur Erzeugung sämtlicher Referenzsignale (4, 5, 14, 15) der eine Oszillator (22) vorgesehen ist.
